# EUROPÄISCHE PATENTANMELDUNG

(11) **EP 1 930 363 A2**
(43) Veröffentlichungstag der Anmeldung: **11.06.2008**
(21) Anmeldenummer: 07023509.8
(22) Anmeldetag: 05.12.2007
(51) Int. Cl.: C08J 7/04, C23C 14/20

(54) **Folien mit Metallbeschichtung**

(30) Priorität: 05.12.2006 DE 102006057237
(71) Anmelder: RKW AG Rheinische Kunststoffwerke, 67227 Frankenthal (DE)
(72) Erfinder: Dirmeier, Oliver, 83512 Wasserburg (DE); Voggenauer, Robert, 83512 Wasserburg (DE); Maier, Leonhard, 83547 Babensham (DE); Morris, Collins, 30161 Rom, GA (US); Franke, Friedrich H, 83137 Schonstett (DE)
(74) Vertreter: Wagner, Jutta

(57) **Zusammenfassung**

Die vorliegende Erfindung betrifft wasserdichte, glatte, mikroporöse Folien aus einem thermoplastischem Polymermaterial, die zumindest auf einer Seite eine metallische Beschichtung mit einer Dicke von 3 bis 300 nm aufweisen, wobei die Schirmungsdämpfung der beschichteten Folie für elektromagnetische Strahlung im Wellenlängenbereich von 1 bis 18 GHz mindestens 23 bis 41 dB beträgt, die Mikroporen eine mittlere Porengröße im Bereich von 0,1 bis 5 µm aufweisen, die Wasserdampfdurchlässigkeit der beschichteten Folie im Bereich von 100 bis 5000 g/m² in 24 h liegt und der Reflektionsgrad im IR gemessen mit der Ulbrichtkugel im Bereich von 50 bis 90 % liegt.

## Beschreibung

Die vorliegende Erfindung betrifft glatte, wasserdichte und wasserdampfdurchlässige Folien mit Metallbeschichtung sowie ein Verfahren zu ihrer Herstellung.

Folien und Verbunde aus Folien mit Substraten wie Vlies, Gewebe, Papier etc. mit einer metallischen Beschichtung sind bekannt. Sie eignen sich z.B. für den Einsatz als Produktschutz, wobei sie das zu schützende Produkt umhüllen.

Weiterhin ist es mit metallisch beschichteten Folien und Verbunden möglich, elektromagnetische Feldfrequenzen über einen weiten Frequenz- bzw. Wellenlängenbereich zu reflektieren und damit auch solche Strahlung abzuschirmen.

Bisher sind Folien und Verbunde mit Metallbeschichtung aber überwiegend wasserdampfdicht. Bei vielen Produktschutzanwendungen ist die absolute Dichtigkeit auch gegen Gase wie Luft und insbesondere Sauerstoff gerade erwünscht Es gibt jedoch auch Anwendungen, besonders im Bereich der Abschirmung von elektromagnetischer Strahlung (Wärme/Kälte, Elektrosmog), bei denen eine Wasserdampfdurchlässigkeit im Sinne einer Atmungsaktivität erwünscht ist. Zu denken ist hier beispielsweise an Schutzbekleidung oder Abschirmungen gegen elektromagnetische Felder für Personen, die einen Schutz vor Elektrosmog wünschen.

US 5,055,338 beschreibt metallisierte, geprägte, wasserdichte und atmungsaktive Folien. Diese weisen jedoch wegen der geprägten Oberfläche für manche Anwendungen unbefriedigende Reflektionsgrade auf. In dem Dokument wird die mittels Prägung erzielte Rauhigkeit der Oberfläche in Zusammenwirkung mit dem Füllstoff als essentiell für eine ausreichende Haftung des aufgedampften Metalls angesehen.

US 5,656,355 beschreibt metallisierte, perforierte, elastische Folien. Durch die Dehnungen geht die für hohe Reflektionsgrade wichtige Ebenheit der Metallbeschichtung verloren, da Risse entstehen und sich die Beschichtung partiell anlöst. Damit sinkt die erwünschte Schirmung der elektromagnetischen Feldfrequenzen.

In EP 1 400 348 wird die Verwendung von metallisierten, atmungsaktiven Folien mit einem Durchmesserbereich der Poren von 0,1 -15 mm beschrieben. Diese Folien weisen eine ungenügende Wasserdichtigkeit auf.

DE 103 49 170 A1 beschreibt Verbunde aus Polyamidfolien mit feuchteabhängigem Diffusionswiderstand und einem elektrisch leitfähigen Vlies zur Abschirmung elektromagnetischer Felder. Es wird bezweifelt, dass eine metallbeschichtete, monolithische Folie sowohl gegenüber Feuchte diffusionsoffen sein als auch gegenüber elektromagnetischen Feldern schützen kann. Im Vergleich zu den in diesem Dokument beschrieben Verbunden mit s_{d} Werten von mindestens 2 m weisen atmungsaktive Folien und Verbunde, welche z.B. als Dachunterspannbahn Verwendung finden sollen, üblicherweise s_{d} Werte von unter 1 m, z.B. 0,02 bis 0,4 m auf. Durch die Dachunterspannbahn ist also ein wesentlich größerer Wasserdampfdurchgang gegeben, als durch die in DE 103 49 170 beschriebenen Dampfbremsen.

WO 2006/024013 beschreibt Verbunde mit einer metallischen Beschichtung, welche insbesondere als Dachunterspannbahn Verwendung finden sollen. Obwohl die Anmeldung die Schichten des Verbundes sehr breit beansprucht, werden nur Verbunde aus Vliesstoffen näher beschrieben. Werte für die erzielte Reflektion sind nicht genannt.

DE 100 41 526 bezieht sich auf Thermoreflexionsfolien für den Baubereich, wobei die Folien entweder wasserdampfundurchlässig oder mittels Perforationen eines Durchmessers von 46 bis 111 µm diffusionsoffen. Auch die EP 1 400 348 beschreibt reflektierende Verbunde, welche durch Perforationen atmungsaktiv gestaltet werden sollen. Der Durchmesser beträgt hier 0,1 bis 15 mm.

Es besteht daher weiter die Aufgabe, wasserdichte, wasserdampfdurchlässige Folien bereitzustellen, die eine Abschirmung elektromagnetischer Strahlung erlauben.

Überraschend wurde nun gefunden, dass eine Metallbeschichtung von wasserdichten und mikroporösen, wasserdampfdurchlässigen Folien möglich ist, ohne dass eine wesentliche Verminderung der Wasserdampfdurchlässigkeit eintritt.

Die obige Aufgabe wird daher gelöst durch Folien aus thermoplastischem Material mit einer metallischen Beschichtung, wobei die Folie wasserdicht, atmungsaktiv und hochreflektierend ist. Die Folien lassen sich zu Verbunden laminieren.

Im Rahmen der vorliegenden Anmeldung haben die verwendeten Begriffe die folgende Bedeutung.

Der Begriff "Folie" bezeichnet eine dünne, flächige Struktur deren Dicke um ein vielfaches geringer ist als die Breite und Länge und die aus polymeren Materialien, insbesondere aus thermoplastischen Polymeren, hergestellt ist. Typische Dicken liegen im Bereich von wenigen µm bis zu einigen mm, z.B. betragen die Dicken 5 bis 300 µm oder 0,1 bis 1 mm, je nach Anwendung. Die Abmessungen in Länge und Breite liegen typischerweise im Bereich von 50 cm bis 5 m Breite und 10 m bis viele 1000 m Länge. Die Folien basieren auf Polymeren, sie können aus einem homogenen Material oder Materialmischungen bestehen. Die Folien können sowohl einlagig als auch mehrlagig, z.B. zwei-, drei-, vier-, fünflagig sein. Mehrlagige Folien werden üblicherweise durch Coextrusion hergestellt.

Der Begriff Verbund bezeichnet ebenfalls dünne flächige Gebilde, wobei Verbunde mindestens eine Folie wie oben beschrieben und zumindest eine weitere Lage aufweisen. Die weitere Lage kann ebenfalls eine Folie sein, oder ein Gewebe, Gewirke oder Netz. Es ist auch möglich, dass die weitere Lage aus Papier oder Karton besteht. Die Verbindung der Folie mit der oder den weiteren Lagen erfolgt in an sich bekannter Weise z.B. durch Kleberlaminierung.

Mit dem Begriff wasserdicht ist gemeint, dass flüssiges Wasser und andere Flüssigkeiten die Folie bzw. den Verbund nicht durchdringen können. Die Wasserdichtigkeit wird mittels hydrostatischem Druckversuch nach DIN 53886 ermittelt. Typischerweise beträgt die Wasserdichtigkeit von etwa 500 mm bis über 1200 mm Wassersäule.

Mit Wasserdampfdurchlässigkeit oder Atmungsaktivität wird die Eigenschaft der erfindungsgemäßen Folien und Verbunde bezeichnet, einen Durchtritt von gasförmigem Wasser durch die Folie bzw. den Verbund zu ermöglichen. Die Wasserdampfdurchlässigkeit wird in der Regel in g Wasser, das pro m² Oberfläche innerhalb von 24 h die Folie bzw. den Verbund passiert, angegeben. Die gemessenen Werte hängen von der Meßmethode und den eingestellten Bedingungen ab. Im Rahmen der vorliegenden Anmeldung werden die Atmungsaktivitäten mit der Dry-Cup-Methode (ASTM E 96-95) bei 40°C und 75% relativer Luftfeuchte gemessen. Die Atmungsaktivität beträgt typischerweise 100 bis 5000 g/m² in 24 h und vorzugsweise 500 bis 3500 g/m² in 24 h. Im Rahmen der Erfindung wird die Wasserdampfdurchlässigkeit durch das Einbringen von Mikroporen in die Folie erreicht. Die Porengröße liegt dabei im Bereich von 0,1 bis 5 µm, vorzugsweise im Bereich von 0,5 bis 2 µm.

Die Reflektionseigenschaften werden durch Messung der Schirmungsdämpfung bestimmt. Hochfrequente elektromagnetische Wellen verhalten sich ähnlich wie Licht, das von Materialien reflektiert wird oder sie durchdringt. Materialien, auf die die elektromagnetischen Wellen treffen, wirken wie ein Schirm. Dass die elektromagnetischen Wellen hinter dem Schirm nicht mehr so stark auftreten wie vor dem Schirm hat zwei Ursachen:
- ein Teil der Wellen wird vom Schirm reflektiert und
- ein weiterer Teil der Wellen wird vom Schirm absorbiert, d. h. im Schirm in Wärme umgewandelt.

Man spricht daher von einer Schirmungsdämpfung, die für die elektrische und die magnetische Feldstärke getrennt angegeben werden kann. Für die Raumbereiche diesseits und jenseits des Schirms sowie für die Schirmwände selbst müssen die Maxwellschen Gleichungen gelöst werden. Aus dem Verhältnis der berechneten Feldstärken vor und hinter dem Schirm wird dann die Schirmwirkung ermittelt. Im Hochfrequenzbereich betrachtet man die elektrischen und magnetischen Felder nicht getrennt Je homogener eine metallisch beschichtete Schirmfläche bzw. ein Schirmgehäuse aufgebaut ist, desto größer ist die Schirmwirkung gegen Wechselfelder. Zur Messung werden die Leistungsflussdichten mittels Spektrumsanalysatoren oder kalibrierten selektiven Feldstärkenmessgeräten bestimmt, wobei die hochfrequente Transmissionsdämpfung in Anlehnung an den Standard IEEE 299-1997 ermittelt wird und der Messaufbau entsprechend MILSTD 285 erfolgt. Die Dämpfung ist dabei ein Maß für die Abschwächung der elektrischen und/oder magnetischen Feldstärke beim Durchgang durch verschiedene Materialien. Zur Ermittlung der Dämpfung werden die zu prüfenden Materialien so zwischen eine Sende- und Empfangsantenne gehängt, dass die Wellen durch die Prüfmaterialien vom Sender zum Empfänger laufen.

Die Schirmungsdämpfung der erfindungsgemäßen Folien bzw. daraus hergestellten Verbunde liegt bei mindestens 23 dB, vorzugsweise bei mindestens 27 dB. Typischerweise erreichen die Folien bzw. Verbunde Schirmungsdämpfungen von über 35 und bis über 40 dB. Das entspricht Schirmungswirkungsgraden im Bereich von 99,9 bzw. 99,99 %.

Ein weiterer wichtiger Parameter ist die Reflektion im IR. Die IR-Reflektionsmessung mit der Ulbrichtkugel erfolgt in einer innen matt verspiegelten Kugel, indem eine Lichtquelle im Inneren (oder die durch eine kleine Öffnung einfallende Strahlung) ein stationäres Strahlungsfeld erzeugt. Dieses Strahlungsfeld wird durch eine an anderer Stelle angebrachte Detektoröffnung gemessen. Die IR-Reflektion nach Ulbricht der metallbeschichteten Folie liegt vorzugsweise im Bereich von 50 bis 90 %, insbesondere von 60 bis 80 % und ganz besonders bevorzugt im Bereich von 62 bis 75 %.

Ein weiterer wichtiger Parameter ist der elektrische Widerstand der metallischen Beschichtung. Der spezifische Oberflächenwiderstand wird nach DIN 53482 ermittelt. Er soll gegenüber den in dünnen Metallbeschichtungen induzierten Wirbelströmen möglichst gering sein und etwa 30 Ω/ Quadrat, vorzugsweise 5 Ω/ Quadrat, nicht überschreiten.

Die erwünschte Schirmungsdämpfung setzt eine glatte metallische Schicht voraus, welche bei den hier angewandten Dicken der Metallbeschichtung nur erreicht wird, wenn die Folie glatt ist. Eine Folie ist glatt im Sinne der vorliegenden Erfindung, wenn die Oberfläche eine Rauhigkeit nach DIN EN ISO 4287 von weniger als 15 µm und insbesondere von weniger als 10 µm und ganz besonders bevorzugt von weniger als 5 µm aufweist. Demgemäss sollte die Folie keine geprägte Oberfläche aufweisen. Weiterhin sollte auch keine dreidimensionale Prägung der Folie vorliegen, da der elektrische Widerstand gegenüber den, in den dünnen Metallbeschichtungen induzierten Wirbelströmen - die die Wärmeerzeugung und damit die Schirmabsorption begründen - möglichst gering sein soll.

Wasserdichte und wasserdampfdurchlässige, glatte Folien und ihre Herstellung sind an sich bekannt, beispielsweise aus US 5,169,712 und US 5,176,953. Bei den erfindungsgemäß bevorzugt eingesetzten, atmungsaktiven und glatten Folien wird das Polymergranulat, z.B. Blockpolymere aus Polyethylen und Polypropylen, vor der Extrusion üblicherweise mit feinkörnigem Inertmaterial - wie z.B. Kalkstein mit mittleren Korngrößen bis 10 µm - gefüllt. Der Kalksteingehalt variiert je nach Verfahrensweg und nachfolgendem Verwendungszweck der Folie beispielsweise zwischen 20 - 60 Gew.-%. Das Polymergranulat mit dem Kalkstein wird z.B. auf einer Blas- oder einer Castanlage zu Precursorfolien extrudiert und anschließend gereckt. Die Reckung der Precursorfolien auf das 1,5- bis 4-fache ihrer Länge und/oder Breite erfolgt biaxial oder monoaxial je nach Verwendungszweck der atmungsaktiven Folien. Die Reckung kann im Prinzip mit jedem Reckverfahren erfolgen, wobei eine glatte, ungeprägte und damit gleichmäßig dicke Folie erzeugt wird. Bei der Reckung wird nur das Polymer, nicht das Inertmaterial gedehnt und verstreckt, so dass im Polymer um das Inertmaterial Mikrorisse und Spalten entstehen, die von einer Folienseite zur anderen reichen. Es werden dann beispielsweise rechnerisch in den atmungsaktiven Folien Poren mit einem Durchmesser von ca. 1 µm ermittelt; ausgezählt unter dem Mikroskop werden etwa 1 Million Löcher/Risse pro cm² Folienoberfläche.

Als Material für die Folie kommen vorzugsweise Polyolefine wie Polyethylen, Polypropylen, Copolymere von Ethylen oder Propylen mit anderen ethylenisch ungesättigten Verbindungen, Terpolymere von Propylen oder Ethylen und Mischungen der vorgenannten Polymere in Betracht. Die Herstellung dieser Materialien ist dem Fachmann bekannt.

Im Rahmen der vorliegenden Erfindung bezieht sich der Begriff Copolymer sowohl auf ataktische Copolymere als auch auf Block-, Stern- und andere Copolymere mit einer nicht statistischen Anordnung der Comonomeren. Der Begriff umfasst ebenso Propfcopolymere.

Geeignete Polypropylene sind zum Beispiel Propylenhomopolymere oder Copolymere von Propylen mit Ethylen, Buten, Hexen, Octen oder anderen ethylenisch ungesättigten Verbindungen. Besonders bevorzugt sind Propylen-Blockcopolymere und Propylen-Random-Copolymere.

Geeignete Polyethylene sind zum Beispiel Polyethylen hoher Dichte (HDPE), Polyethylen niederer Dichte (LDPE) oder lineares Polyethylen niederer Dichte (LLDPE).

In einer ersten bevorzugten Ausführungsform wird als thermoplastisches Material eine Mischung aus Propylen-Blockcopolymer und Propylen-Random-Copolymer eingesetzt, der auch bis zu 25 Gew.-% Polyethylen zugemischt sein kann. In einer zweiten besonders bevorzugten Ausführungsform wird als thermoplastisches Material eine Mischung aus mindestens zwei Polyethylenen (LLDPE und LDPE) eingesetzt, wobei hier bis zu 20 Gew.-% Polypropylen beigemischt sein kann.

Diesen Mischungen wird dann zur Erzeugung der Atmungsaktivität feinkörniger, inerter Füllstoff in einer Menge von vorzugsweise 25 bis 65 Gew.-%, insbesondere von 40 bis 55 Gew.-% zugesetzt.

Als Füllstoff eignen sich im Prinzip alle üblichen anorganischen und organischen Materialien, beispielweise Calciumcarbonat, Talkum, Lehm, Kaolin, Silikon, Kieselerde, Magnesiumcarbonat, Bariumcarbonat, Magnesiumsulfat, Bariumsulfat, Calciumsulfat, Aluminiumhydroxid, Zinkoxid, Magnesiumhydroxid, Calciumoxid, Magnesiumoxid, Titanoxid, Tonerde, Glimmer, Glaspuder, Zeolithe, Silikonlehm, Zellulosepuder, Polytetrafluoroethylenpuder und aromatische Polyamid- und/oder Polyurethanpuder. Bevorzugt wird feinkörniges Calciumcarbonat. Das Füllmaterial kann in an sich bekannter Weise beschichtet sein. Die mittlere Teilchengröße sollte vorzugsweise im Bereich von 0,8 bis 10 µm liegen.

Die Herstellung der erfindungsgemäßen Folien erfolgt zunächst in an sich bekannter Weise z.B. über Blas- oder Castextrusion aus den mit inertem Füllstoff versetzten thermoplastischen Materialien und einer anschließenden Reckung: beispielsweise biaxial, monoaxial oder auch durch Ringrolling. Die Folien sind jedoch nicht geprägt, um eine möglichst glatte Oberfläche mit einer Rauhigkeit von maximal 15 µm, bevorzugt von nicht mehr als 10 µm und insbesondere von maximal 5 µm, zu erhalten.

Die glatten, wasserdichten und mikroporösen Polymerfolien werden dann erfindungsgemäß mit Metall beschichtet, insbesondere mit Metall bedampft.

Bevorzugte Metalle sind Aluminium, Mangan, Zink, Eisen, Nickel, Kobalt, Zinn, Wismut, Kupfer, Silber, Palladium, Rhodium, Platin, Gold, Titan, Antimon, Wolfram, Molybdän, Vanadium, Chrom. Besonders bevorzugt ist Aluminium. Legierungen oder Mischungen von Metallen, insbesondere nichtrostender Stahl, sind ebenfalls geeignet. Die Art des Metalls richtete sich vor allem nach der Anwendung und nach den Kosten. So sind Aluminiumbeschichtungen sehr stabil und kostengünstig und z.B. für Dachunterspannbahnen bevorzugt. Wenn die Reflektion im Infrarotbereich zur Wärme/Kälteisolation im Vordergrund steht, kann Gold bevorzugt sein, obwohl es unter Kostengesichtspunkten nicht vorteilhaft ist. Im Medizinbereisch ergibt sich durch die antibakterielle Wirksamkeit von Silber unter Umständen trotz der entsprechenden Kosten ein Vorteil.

Die Dicke der metallischen Schicht beträgt typischerweise 3 bis 300 nm, insbesondere 50 bis 250 nm. Höhere Dicken sind häufig nicht ausreichend flexibel oder unter Kostengesichtspunkten nicht akzeptabel. Wird die metallische Schicht zu dünn, vermindert sich die Schirmungsdämpfung.

Dünne Schichten, üblicherweise unter 1 µm Dicke, lassen sich durch verschiedene Verfahren auf die Folie aufbringen. Gemeinsames Merkmal dieser Verfahren ist die Abscheidung von Material aus der Gasphase, im Vakuum, bei reduziertem Gasdruck und/oder aus dem Plasmazustand durch chemische und/oder physikalische Prozesse. Diese Möglichkeit zur Kombination von physikalischen und chemischen Prozessen bei unterschiedlichen Betriebsbedingungen führt zu einer Vielfalt verschiedener Techniken. Die Abscheidung der Schichten erfolgt üblicherweise über physikalische Verfahren PVD (Physical Vapor Deposition), z. B. durch Bedampfen oder durch Sputtern. Alternativen dazu sind die chemische Gasphasenabscheidung CVD (Chemical Vapor Deposition), die Plasmapolymeri-sation oder auch die Atomlagenabscheidung ALD (Atomic Layer Deposition), ein stark verändertes CVD-Verfahren.

Die Beschichtung erfolgt erfindungsgemäß vorzugsweise durch eine Kathodenzerstäubung (Sputtern), wobei im Vergleich zum Aufdampfen eine festere Haftung zwischen Folie und Beschichtung erreicht wird. Die Sputterdeposition hat gegenüber dem Aufdampfen den weiteren Vorteil, dass bei Legierungen die Metalle im gleichen Verhältnis wie in der Legierungszusammensetzung auf die Folie aufgebracht werden. Bei der Kathodenzerstäubung wird in einer inerten Stickstoffatmosphäre oder im Vakuum der Film als Trägermaterial über eine Walze, die Anode, geführt. Parallel zu der Walzenachse sind Kathoden angeordnet, die die Beschichtungsmaterialien tragen. Mit einer sehr hohen Kathodenspannung lassen sich einzelne Atome des Beschichtungsmaterials herauslösen und auf das Trägermaterial "schießen" (= sputtern).

Alternativ, aber nicht bevorzugt, kann die Metallbeschichtung auch durch eine herkömmliche Bedampfung bzw. durch plasmagestützte Aufdampfverfahren im Vakuum bei Drücken bis unter 1 mbar erfolgen. Beispielsweise gehört das VALICO®-Verfahren, das Vakuum-Lichtbogen gestützte Aufdampfen, zu diesen plasmagestützten Beschichtungsverfahren; es wird bereits für die Metallisierung von Kunststoffen eingesetzt.

Die Metallhaftung kann zusätzlich durch eine Oberflächenaktivierung der Folie verbessert bzw. gleichmäßiger gemacht werden. Dabei wird zur Verbesserung der Haftung die Oberflächenenergie und damit der Anteil polarer Gruppen auf der Folienoberfläche erhöht. Die Aktivierung von Oberflächen kann durch eine sogenannte Beflammung, bei der die Oberfläche mit einer Gasflamme aktiviert wird oder durch eine Corona-Entladung, ein Verfahren zur Plasmabehandlung unter Atmosphärendruck, erfolgen. Eine konventionelle Corona-Vorbehandlung der zu beschichtenden Folienseite erhöht die Metallhaftung und vor allem die Stabilität der Verbindung von Metall und Folie für längere Zeiträume. Die Folie erfährt im Verfahrensablauf beim nachfolgenden Sputtern als bevorzugtes Beschichtungsverfahren ebenfalls eine Erhöhung ihrer Oberflächenenergie. Für Beschichtungen, die nicht langzeitstabil sein müssen, kann vor dem Sputtern die Oberflächenvorbehandlung entfallen.

Alternativ oder zusätzlich kann die Metallhaftung auch durch einen Primer-Auftrag auf die zu beschichtende Folie verbessert werden.

Vor der Metallbeschichtung der mikroporösen Folie wird vorzugsweise die Oberflächenenergie der zu beschichtenden Folienseite gleichmäßig auf 35 bis 44 mN/m, vorzugsweise 37 bis 39 mN/m eingestellt. Die Messung der Oberflächenenergie erfolgt analog DIN ISO 8296 (9-2003) bzw. ASTMD 2578-99a (2004) mittels Bestimmung der Benetzbarkeit durch Prüftinten. Die Benetzbarkeit wird dabei mit Hilfe des Randes von Pinselstrichen einer Reihe von Prüftinten gemessen, wobei eine Reproduzierbarkeit von ± 0,5 mN/m typisch ist. Unbehandelte Folien aus Polyethylen hoher oder niedere Dichte und Polypropylen weisen Oberflächenenergien im Bereich von 31 bis 33 mN/m auf, die aber örtlich stark variieren können und auch durch Additive beeinflusst werden.

Gemäß einer weiteren bevorzugten Ausführungsform werden die Folien nach der Metallisierung, z. B. nach einer Aluminiumbeschichtung, auf der metallbeschichteten Oberfläche schulzlackiert. Hierfür verfügt der Markt über eine Vielzahl von Schutzlackierungen, z. B. 0,8 - 30 g/m²-Überzüge mit Acryl-, Polyurethan- oder Polyesterlack. Insbesondere eignet sich hierzu Polyurethan-Lack. Die Oberfläche kann auch durch Aufbringen einer weiteren Folienlage geschützt werden, z.B. durch Direktextrusion. Es versteht sich, dass z.B. für die Anwendung als kälte- oder wärmeisolierende Decke oder Verpackung die Schutzschicht die zu reflektierende Strahlung nicht absorbieren darf. Ebenso muss die Schutzbeschichtung eine ausreichende Atmungsaktivität besitzen.

Es ist weiter bevorzugt, dass die Folien eine gleichmäßige Dicke aufweisen, da hierdurch unter anderem eine homogene Wasserdampfdurchlässigkeit und eine gleichmäßig hohe Schirmungsdämpfung erzielt wird. Sofern eine bereichsweise unterschiedliche Atmungsaktivität gewünscht ist, kann natürlich über eine entsprechende Variation der Foliendicke auch gezielt eine örtlich variierende Atmungsaktivität eingestellt werden.

Die erfindungsgemäßen Folien weisen bei hoher Abriebbeständigkeit und Knickfestigkeit eine hohe Schirmungsdämpfung elektromagnetischer Feldfrequenzen auf. Die erfindungsgemäßen mikroporösen Folien sind weiterhin wasserdicht, z.B. bei einer Dicke von 25 µm bis über 1 m-Wassersäule, und atmungsaktiv bis über 1500 g Wasserdampf/m² in 24 h. Sie können damit in einem breiten Anwendungsbereich eingesetzt werden. Dieser Bereich erstreckt sich von der Wärmereflektion im nahen Infrarotbereich bis zur Abschirmung von sogenanntem Elektrosmog, wobei dann in der Regel die Folien zur Abführung induzierter Ströme geerdet werden. Dies bedeutet, dass bei den Folien der Anwendungsbereich beim Schutz des umhüllten Produktes beispielsweise sowohl zur verlängerten Frisch- und Konsistenzerhaltung von warm bzw. kühl zu haltenden Lebensmitteln als auch zur Abwehr von störendem Elektrosmog von Gebäuden oder einzelnen Räumen reicht. Dabei wird aufgrund der Atmungsaktivität der eingesetzten metallbeschichteten Folien ein Nässestau im zu schützenden Produkt/Objekt vermieden.

Ein bevorzugtes Anwendungsgebiet der erfindungsgemäßen Folien besteht im Einsatz als Lage zur Regelung der Dampfdurchlässigkeit bei Bauwerken, z.B. als Dachunterspannbahn. Bevorzugt werden hierbei für die Sommermonate - aufgrund ihrer erhöhten Gebrauchstemperaturen - wasserdichte, wasserdampfdurchlässige Polypropylenfolien.

Eine weitere Anwendung ergibt sich bei Medikalprodukten, bei denen insbesondere eine Beschichtung mit Silber vorteilhaft sein kann. Für die Versorgung von Hautwunden steht eine breite Palette an fertigem Verbandsmaterial zur Verfügung. Alle Schäden der Haut bergen eine Infektionsgefahr. Deshalb sollte die Wunde selbst nur mit sterilem (keimfreiem) Verbandsmaterial bedeckt werden. Metallisierte Wundauflagen werden bei Verbrennungen und Verätzungen eingesetzt; sie besitzen eine nicht verklebende Wirkung. Im Medizinbereich werden auch die aseptischen und fungiziden Eigenschaften eines Silberauftrags gezielt genutzt. Wundauflagen mit Silberauftrag sind sowohl für Brandverletzte als auch für wundgelegene Langzeit-Patienten geeignet. Im Vergleich zu anderen Antiseptika wirkt Silber in geringen Konzentrationen über einen langen Zeitraum hinweg auf eine Vielzahl von Infektionskeimen ein. Mikroorganismen zeigen nur eine geringe Neigung, Resistenzen gegen silberhaltige Produkte zu entwickeln. Das allergene Potential von Silber ist vergleichsweise gering..Silber ist nahezu ungiftig - wenn nicht extrem hohe Konzentrationen verwendet werden.

Die Erfindung soll anhand der nachfolgenden Beispiele näher veranschaulicht werden, ohne jedoch auf die konkret beschriebenen Ausführungsformen beschränkt zu sein. Soweit nicht ausdrücklich anders angegeben, beziehen sich im Rahmen der vorliegenden Anmeldung sämtliche Angaben von % und Teilen auf das Gewicht.

### Beispiele

### Herstellung

Eine handelsübliche glatte Polypropylenblasfolie (28 - 30 µm, 25 g/m², Aptra® B145, von RKW AG Rheinische Kunststoffwerke, DE) wurde erfindungsgemäß auf einer Seite mit Aluminium beschichtet.

Die Folie wurde einseitig für die Metallbeschichtung mittels Corona-Entladung vorbehandelt, die Oberflächenenergie wurde damit gleichmäßig auf etwa 38 mN/m eingestellt.

Die Metallabscheidung der ca. 1400 °C heißen Aluminiumionen erfolgte auf der Corona-vorbehandelten Folienseite; die hierzu im Vakuum bei 10 mbar über eine Kühlwalze bei etwa - 20 °C läuft.

### Eigenschaften

Die erfindungsgemäßen Folien sind bei Belastungen bis über 1 m-Wassersäule wasserdicht.

Sowohl bei den unbedampften als auch bei den bedampften Folien wurden die Wasserdampf-Durchlässigkeit, der elektrische Oberflächenwiderstand und die hochfrequente Transmissionsdämpfung ermittelt.

### Wasserdampfdurchlässigkeit

Die Wasserdampf-Durchlässigkeit wurde bei der atmungsaktiven, glatten, ungeprägten Blasfolie mit der Dry-Cup-Methode (ASTM E96-95, 40 °C / 75 % rh) vor und nach der einseitigen Bedampfung mit 55, 75, 90 und 160 nm Aluminium gemessen. Die Ergebnisse zeigt Tabelle 1.

| Aluminiumbeschichtung [nm] | Wasserdampfdurchlässigkeit [g/m² in 24 h] |
|---|---|
| 0 (unbeschichtet) | 1627 |
| 55 | 1687 |
| 75 | 1571 |
| 90 | 1587 |
| 160 | 1529 |

Bei der einseitig aluminiumbeschichteten Glattfolie erniedrigt sich gegenüber der unbeschichteten, glatten Blasfolie die Wasserdampf-Durchlässigkeiten. Sie sinkt um etwa 6 % bei der einseitig aluminiumbeschichteten, atmungsaktiven, glatten, ungeprägten Blasfolie.

### Schutzbeschichtung

Dünne Aluminiumbeschichtungen sind empfindlich gegenüber sauren Produkt-und Umweltbedingungen. Darüber hinaus können Aluminiumbeschichtungen auch den menschlichen Stoffwechsel beeinflussen; manche Personen reagieren allergisch auf Aluminium. Durch einen Lacküberzug aus Polyurethan-Lack (Auftragsdicke von 28 g Polyurethan-Trockengewicht/m²) sanken zwar die Wasserdampf-Durchlässigkeiten bei der aluminiumbeschichteten Glattfolie; gemessen wurde eine Verminderung auf Werte von 235 - 348 g Wasserdampf/m² in 24 h.
Diese Wasserdampfdurchlässigkeit war für die vorgesehene Anwendung als Dachunterspannbahn ausreichend.

### Reflektionsgrad

Die IR-Reflelctionsmessung mit der Ulbrichtkugel erfolgt in einer innen matt verspiegelten Kugel, indem eine Lichtquelle im Inneren (oder die durch eine kleine Öffnung einfallende Strahlung) ein stationäres Strahlungsfeld erzeugt. Dieses Strahlungsfeld wird durch eine an anderer Stelle angebrachte Detekloröffnung gemessen. Die IR-Reflektion nach Ulbricht der mit 55, 90 und 160 nm aluminiumbeschichteten, atmungsaktiven, glatten 25 µm Blasfolie variiert von 62-75 %.

### Oberflächenwiderstand

Bei den Folien wurden anschließend jeweils von den aluminiumbeschichteten Flächen elektrische Oberflächenwiderstände nach DIN 53482 ermittelt, die im Bereich von 1,7-0,7 Ω/ Quadrat liegen.

### Abschirmung

Die Messung erfolgt in Anlehnung an den Standard IEEE 299-1997 bei einem Messaufbau entsprechend MILSTD 285. Die Folien wurden in einem etwa 2-3 cm breiten Spalt zwischen einem Hochfrequenz-Sender und einem angepassten Empfänger auf ihre Schirmungsdämpfung hin geprüft. Als Frequenzen wurden dabei 1-18 GHz durchfahren. Die Schirmungsdämpfung von ca. 30 dB bei Frequenzen von 1-18 GHz, die bei der Folie bei einem Aluminiumauftrag von 55 nm beobachtet wird, entspricht einem Leistungsdurchlass von 0,1 % bzw. einer Schirmungsdämpfung von 99,9 %.

### Vergleich der Reflektion bei erfindungsgemäßen Folien und solchen nach US 5,055,338

Erfindungsgemäße Folien und solche nach US 5,055,338 wurden hinsichtlich der Reflexion verglichen. Dazu wurden Ausgangsfolien mit einer Dicke von 30 µm mit 70 nm Al beschichtet und anschließend mit einer atmungsaktiven Schutzlackierung, Schichtdicke 2 g/m², versehen. Die Reflektion nach Ulbricht für Strahlung einer Wellenlänge 1100 µm wurde für beide Folien wie oben angegeben bestimmt. Die erfindungsgemäße, glatte Folie erreichte eine Reflexion von 63 % während die schmelzgeprägte Folie eine Reflexion von 46 % aufweist. Die Schwankungsbreite der Reflexion lag bei ca. 5 %, der gemessene Unterschied ist somit signifikant. Es zeigt sich demnach, dass die erfindungsgemäße Gtattfolie gegenüber der aus US 5,055,338 bekannten, geprägten Folie eine deutlich bessere Reflexion aufweist. Je geringer die Rauhigkeit der Ausgangsfolie ist, desto besser ist die Reflexion der metallbeschichteten und gegen Witterungseinflüsse geschützten Folie.

## Patentansprüche

1. Wasserdichte, glatte, mikroporöse Folie aus einem thermoplastischem Polymermaterial, **dadurch gekennzeichnet, dass** die Folie zumindest auf einer Seite eine metallische Beschichtung mit einer Dicke von 3 bis 300 nm aufweist, wobei die Schirmungsdämpfung der beschichteten Folie für elektromagnetische Strahlung im Wellenlängenbereich von 1 bis 18 GHz mindestens 23 bis 41 dB beträgt, die Mikroporen eine mittlere Porengröße im Bereich von 0,1 bis 5 µm aufweisen, die Wasserdampfdurchlässigkeit der beschichteten Folie im Bereich von 100 bis 5000 g/m² in 24 h liegt und der Reflektionsgrad im IR gemessen mit der Ulbrichtkugel im Bereich von 50 bis 90 % liegt.

2. Folie gemäß Anspruch 1, **dadurch gekennzeichnet, dass** das Polymermaterial ausgewählt ist unter Polyethylen, Polypropylen, Polyamid, Polyurethan oder deren Mischungen.

3. Folie gemäß Anspruch 2, **dadurch gekennzeichnet, dass** das Polymermaterial eine Mischung aus Polypropylen und Polyethylen ist.

4. Folie gemäß einem der Ansprüche 1 bis 3, **dadurch gekennzeichnet, dass** die Folie eine Dicke von 8 bis 250 µm hat.

5. Folie gemäß einem der Ansprüche 1 bis 4, **dadurch gekennzeichnet, dass** die metallische Beschichtung aus Aluminium, Mangan, Zink, Eisen, Nickel, Kobalt, Zinn, Wismut, Kupfer, Silber, Palladium, Rhodium, Platin, Gold, Titan, Antimon, Wolfram, Molybdän, Vanadium, Chrom oder deren Mischungen besteht.

6. Folie gemäß einem der Ansprüche 1 bis 5, **dadurch gekennzeichnet, dass** die metallische Beschichtung mit einer atmungsaktiven Schutzschicht versehen ist.

7. Folie gemäß Anspruch 6, **dadurch gekennzeichnet, dass** die Schutzschicht ein Lack oder eine Polymerschicht mit einem Flächengewicht im Bereich von 0,5 bis 30 g/m² ist.

8. Verfahren zur Herstellung von wasserdichten, mikroporösen, reflektierenden Folien umfassend die Schritte
a) Extrudieren einer Mischung aus einem thermoplastischem Polymermaterial und einem Inertmaterial mit einem mittleren Durchmesser im Bereich von 0,8 bis 10 µm zu einer Precursorfolie
b) Recken der Precursorfolie zu einer mikroporösen, atmungsaktiven Folie mit einer Oberflächenrauhigkeit von maximal 15 µm und einer mittleren Porengröße im Bereich von 0,1 bis 5 µm
c) Beschichten mindestens einer Seite der Folie mit einem Metall in einer Dicke von 3 bis 300 nm.

9. Verfahren gemäß Anspruch 8, **dadurch gekennzeichnet, dass** die metallische Beschichtung mit einer atmungsaktiven Schutzschicht in Form eines Lackes oder einer polymeren Beschichtung versehen wird.

10. Verfahren gemäß Anspruch 8 oder 9, **dadurch gekennzeichnet, dass** vor der Beschichtung in Schritt c die Oberflächenenergie der zu beschichtenden Folienseite mittel Beflammung oder Coronaentladung gleichmäßig auf von 35 bis 44 mN/m vorzugsweise auf 37 bis 39 mN/m eingestellt wird.

11. Verfahren gemäß einem der Ansprüche 8 bis 10, **dadurch gekennzeichnet, dass** die Beschichtung mittels Kathodenzerstäubung erfolgt.

12. Verwendung der Folien gemäß Anspruch 1 bis 7 im Baubereich, als Medizinprodukt oder als Verpackung.

13. Verwendung gemäß Anspruch 12, **dadurch gekennzeichnet, dass** die Folie eine Dachunterspannbahn ist.

14. Verwendung gemäß Anspruch 12, **dadurch gekennzeichnet, dass** die Folie eine Isolierdecke oder Teil einer Wundauflage ist.

15. Verwendung gemäß Anspruch 12, **dadurch gekennzeichnet, dass** die Folie eine Verpackung ist.
